# EUROPEAN PATENT SPECIFICATION

(11) **EP 4 561 025 B1**
(45) Date of publication and mention of the grant of the patent: **30.09.2026**
(21) Application number: 24150747.4
(22) Date of filing: 08.01.2024
(51) Int. Cl.: H04L 67/565, H04L 67/5651, H04L 69/22

(54) **REDUCING A MEMORY SIZE OF A SYSTEM GENERATED MESSAGE PRIOR TO TRANSMISSION**
REDUZIERUNG DER SPEICHERGRÖSSE EINER SYSTEMERZEUGTEN NACHRICHT VOR DER ÜBERTRAGUNG
RÉDUCTION DE LA TAILLE DE MÉMOIRE D'UN MESSAGE GÉNÉRÉ PAR UN SYSTÈME AVANT TRANSMISSION

(30) Priority: 27.11.2023 US 202318519473
(43) Date of publication of application: 28.05.2025
(73) Proprietor: Juniper Networks, Inc., Sunnyvale, CA 94089 (US)
(72) Inventor: NARENDRA, Manjunath Subhas, Sunnyvale, 94089 (US); JONNADULA, Pavan Lakshmi Kumar, Sunnyvale, 94089 (US); J S, Sheeja, Sunnyvale, 94089 (US); VISHWANATHAN, Suresh, Sunnyvale, 94089 (US)
(74) Representative: Marks & Clerk LLP

(56) References cited:
- US-B1- 7 953 881
- ANONYMOUS: "logging - Why do most log files use plain text rather than a binary format? - Software Engineering Stack Exchange", 27 March 2023 (2023-03-27), XP093177877, Retrieved from the Internet <URL:https://web.archive.org/web/20230327002246/https://softwareengineering.stackexchange.com/questions/332757/why-do-most-log-files-use-plain-text-rather-than-a-binary-format>
- PEON GOOGLE R ET AL: "HPACK - Header Compression for HTTP/2; draft-ietf-httpbis-header-compression-08.txt", HPACK - HEADER COMPRESSION FOR HTTP/2; DRAFT-IETF-HTTPBIS-HEADER-COMPRESSION-08.TXT, INTERNET ENGINEERING TASK FORCE, IETF; STANDARDWORKINGDRAFT, INTERNET SOCIETY (ISOC) 4, RUE DES FALAISES CH- 1205 GENEVA, SWITZERLAND, 17 June 2014 (2014-06-17), pages 1 - 62, XP015099607
- ANONYMOUS: "RFC 9113 - HTTP/2", 1 June 2022 (2022-06-01), XP093178509, Retrieved from the Internet <URL:https://datatracker.ietf.org/doc/html/rfc9113>
- KROGH JESPER: "MySQL Compressed Binary Logs - Jesper's MySQL Blog", 7 May 2020 (2020-05-07), XP093365868, Retrieved from the Internet <URL:https://mysql.wisborg.dk/2020/05/07/mysql-compressed-binary-logs/>

## Description

### BACKGROUND

Network address translation (NAT) is a method for translating network address information in packet headers. Either or both of a source address and a destination address in a packet may be translated with NAT. NAT may include translations of port numbers as well as network (e.g., Internet protocol (IP)) addresses.
US 7 953 881 B1 relates to network characteristic-based compression of network traffic.

### SUMMARY

Particular aspects are set out in the appended independent claims. Various optional embodiments are set out in the dependent claims. Some implementations described herein relate to a method. The method is described in claim 1.

Some implementations described herein relate to a network device. The network device is described in claim 8.

Some implementations described herein relate to a computer-readable medium and are described in claim 14.

### BRIEF DESCRIPTION OF THE DRAWINGS

Figs. 1A-1H are diagrams of an example associated with reducing a memory size of a system generated message prior to transmission.
Fig. 2 is a diagram of an example environment in which systems and/or methods described herein may be implemented.
Figs. 3 and 4 are diagrams of example components of one or more devices of Fig. 2.
Fig. 5 is a flowchart of an example process for reducing a memory size of a system generated message prior to transmission.

### DETAILED DESCRIPTION

The following detailed description of example implementations refers to the accompanying drawings. The same reference numbers in different drawings may identify the same or similar elements.

A system logging protocol (e.g., syslog) provides logging that allows a network administrator to monitor and manage logs from different parts of a network. Messages (e.g., syslog messages) may be generated by a system (e.g., a network device) when traffic sessions are created, when traffic sessions are translated (e.g., via NAT), when traffic sessions are passed through a firewall or a service, and/or the like. The syslog messages may be utilized to analyze traffic patterns and/or subscriber usage, for billing purposes, and/or the like. With the tremendous growth in technology and the increase in subscriber traffic and service requirements, network devices are generating more and more syslog messages. Thus, memory sizes of syslog messages are becoming a serious bandwidth issue. General purpose memory size compression techniques operate on data but without any knowledge of a structure or semantics of the data being compressed, whereas syslog messages include a fixed and well-defined structure with repetitive elements that is not utilized by such generalized techniques.

Thus, current techniques for handling system generated messages (e.g., syslog messages) consume computing resources (e.g., processing resources, memory resources, communication resources, and/or the like), networking resources, and/or the like, associated with failing to reduce memory sizes of large quantities of syslog messages, restricting bandwidth of a network device and/or a network based on failing to reduce the memory sizes of the large quantities of syslog messages, causing lost traffic in a network based on failing to reduce the memory sizes of the large quantities of syslog messages, and/or the like.

Some implementations described herein relate to a network device that reduces a memory size of a system generated message prior to transmission. For example, a network device may receive traffic associated with a network, and may generate a system message based on the traffic. The network device may convert the system message into a binary message, and may compress the binary message to generate a compressed binary message. The network device may provide the compressed binary message to a server device, and the server device may process the compressed binary message, with a decoder, to generate the system message.

In this way, the network device reduces a memory size of a system generated message prior to transmission. For example, the network device may provide a new framer layer to a syslog message. The new framer layer may enable the network device to convert a syslog message from textual format to a binary format, and compress the binary formatted syslog message to generate a compressed binary syslog message. The network device may forward the compressed binary syslog message to a server device for further processing. Thus, the network device conserves computing resources, networking resources, and/or the like that would otherwise have been consumed by failing to reduce memory sizes of large quantities of syslog messages, restricting bandwidth of a network device and/or a network based on failing to reduce the memory sizes of the large quantities of syslog messages, causing lost traffic in a network based on failing to reduce the memory sizes of the large quantities of syslog messages, and/or the like.

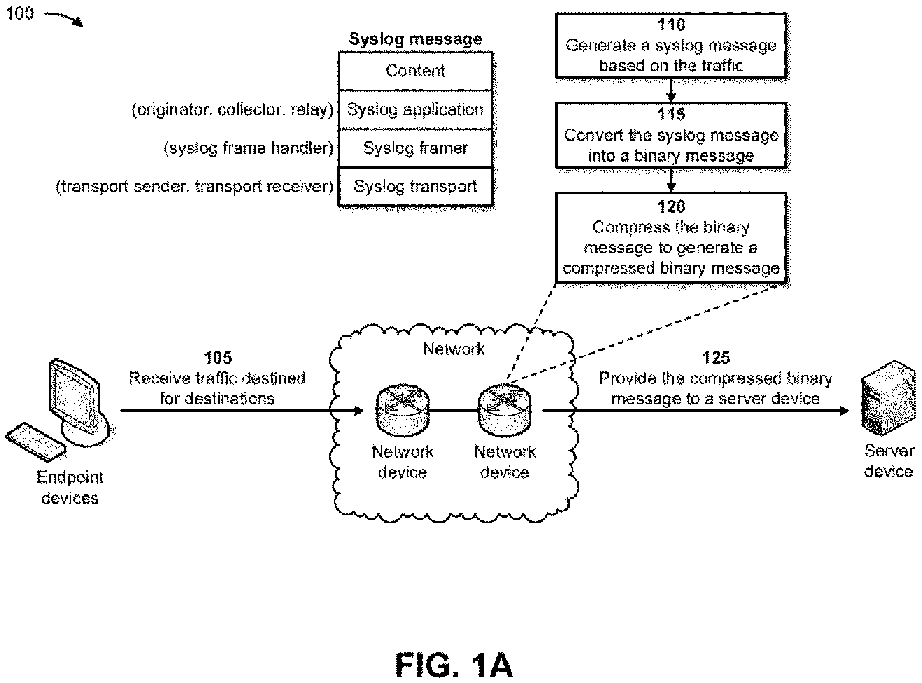

Figs. 1A-1H are diagrams of an example 100 associated with reducing a memory size of a system generated message prior to transmission. As shown in Figs. 1A-1H, example 100 includes endpoint devices and a server device associated with a network of network devices. Further details of the endpoint devices, the server device, the network, and the network devices are provided elsewhere herein.

As shown in Fig. 1A, and by reference number 105, a network device may receive traffic destined for destinations. For example, the network device may receive, from the endpoint devices, traffic destined for other endpoint devices and/or the server device. In another example, the network device may receive, from the server device, traffic destined for one or more of the endpoint devices. In some implementations, the network device may receive the traffic from another network device of the network.

As further shown in Fig. 1A, and by reference number 110, the network device may generate a syslog message based on the traffic. For example, the network device may generate a system message (e.g., a syslog message) when a traffic session is created for the traffic by the network device, when the traffic session is translated (e.g., via NAT) by the network device, when the traffic session is passed through the network device, and/or the like. As further shown, the syslog message may include a content layer, a syslog application layer (e.g., that identifies an originator of the message, a collector of the message, and/or a relay of the message), a syslog framer layer (e.g., a syslog frame handler), and a syslog transport layer (e.g., that identifies a transport sender and/or a transport receiver). In some implementations, the syslog framer layer may cause the network device to convert the syslog message into a binary format, to apply compression or decompression, and to send or receive the syslog message.

As further shown in Fig. 1A, and by reference number 115, the network device may convert the syslog message into a binary message. For example, the syslog framer layer may cause the network device to convert the syslog message from a textual format to a binary format (e.g., a binary message). The binary message may include an augmented Backus-Naur form (ABNF) format except for interpretation of a STRUCTURED-DATA-BINARY field in the binary message. The interpretation of the STRUCTURED-DATA-BINARY field may include a binary representation rather than textual (e.g., ASCII) characters. As such, a field with a length of one bit values %x0 / %x1 may be represented as a single bit whose value is "0" or "1," and not a full byte (octet) that stands for characters "0" or "1" in the ASCII encoding. In ABNF, a specific mapping (encoding) of values into a character set may be specified. Here, the specified encoding is a binary encoding where each terminal value may be encoded in a specified quantity of bits, which varies as per a format defined for the transmission control protocol (TCP) and the user datagram protocol (UDP). In some implementations, the network device may perform Huffman encoding of the syslog message prior to converting the syslog message into the binary message.

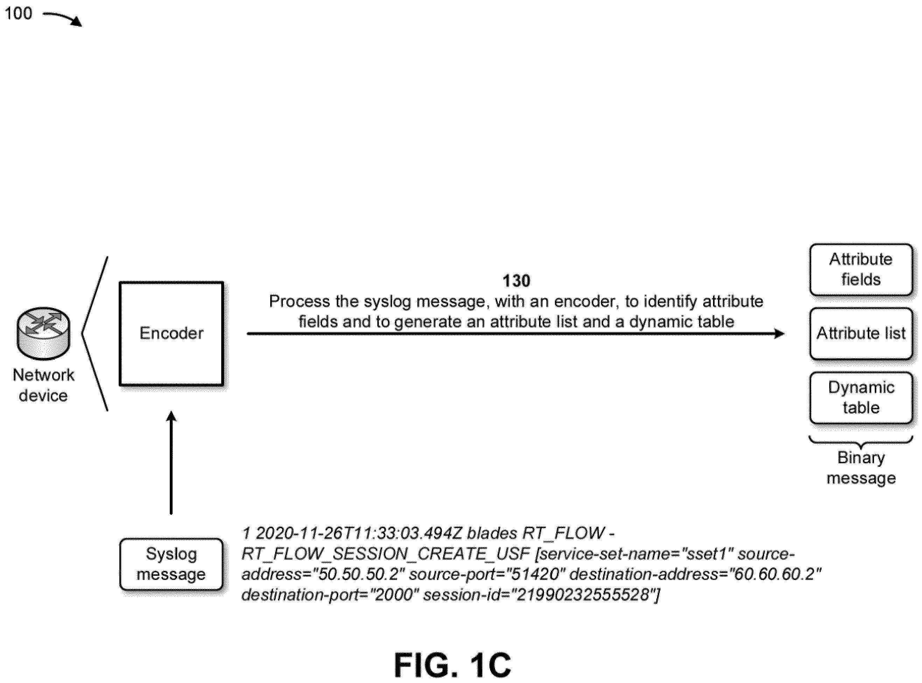

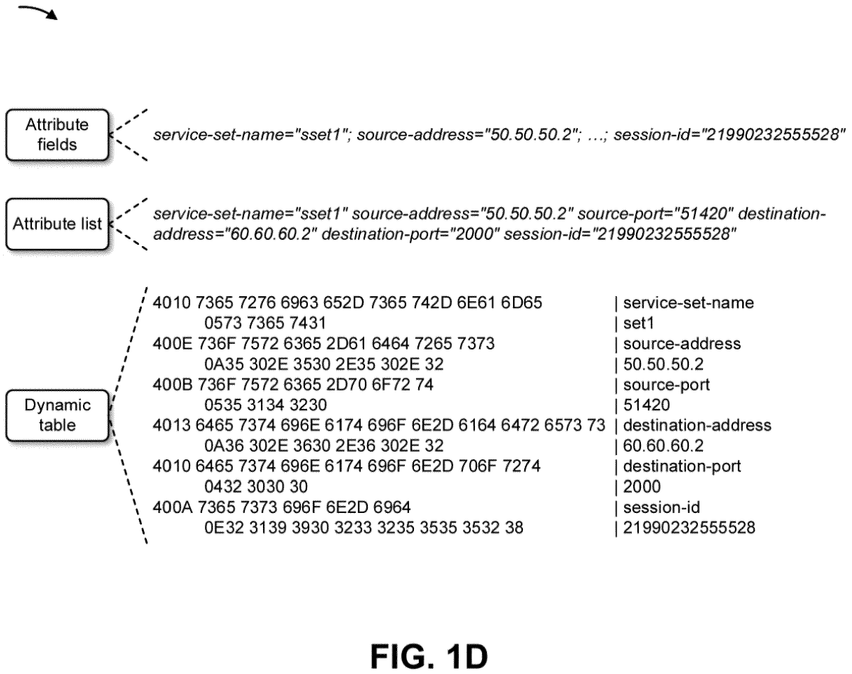

In some implementations, when converting the syslog message into the binary message, the network device may process the syslog message, with an encoder, to identify attribute fields, to generate an attribute list based on the attribute fields, and to generate a dynamic table based on the attribute list. The binary message may correspond to the dynamic table. The encoder may include a header compression for hypertext transfer protocol (HTTP) encoder, a header compression for system log (syslog) attribute pairs similar to HTTP/2 encoder, and/or the like. The dynamic table may be maintained in a first-in, first-out order and may be bounded by a memory threshold. Further details of processing the syslog message with the encoder are provided below in connection with Figs. 1C and 1D.

As further shown in Fig. 1A, and by reference number 120, the network device may compress the binary message to generate a compressed binary message. For example, when the network device processes the syslog message, with the encoder, to generate the dynamic table, the encoder may compress the binary message to generate the compressed binary message. In some implementations, when compressing the binary message to generate the compressed binary message, the network device may utilize field section compression to compress a set of field lines of the binary message to form a field block. Further details of the field section compression are provided below in connection with Figs. 1C and 1D.

A field section may include a collection of field lines. Each of the field lines in a field block may include a single value. A serialized field block may be divided into one or more octet sequences, called field block fragments. A first field block fragment may be transmitted within frame payload of structured data, which may be followed by continuation frames to carry subsequent field block fragments. A receiving device (e.g., the server device) may reassemble the field block by concatenating its fragments and decompressing the block to reconstruct the field section. A complete field section may include a single structured data frame with an end structured data flag set, or a structured data frame with the end structured data flag unset and one or more continuation frames, where a last continuation frame may include the end structured data flag set. Field block fragments may be sent as a frame payload of structured data or continuation frames because these frames carry data that can modify the compression context maintained by the receiving device. The receiving device may reassemble field blocks and perform decompression even if the frames are to be discarded. The receiving device may terminate a connection with a connection error if it does not decompress a field block.

Field compression is stateful and the network device and/or the server device may include an encoder context and a decoder context for encoding and decoding all field blocks on a connection. The dynamic table may define a primary state for each context. The dynamic table may include a maximum size that is set by a decoder. The network device and/or the server device may communicate the size chosen by the decoder context using a header table size setting. When a connection is established, the dynamic table size for the decoder and the encoder may include an initial value of the header table size setting. Any change to the maximum value set using the header table size setting may take effect when the settings message is sent by the encoder. The encoder may set the dynamic table to any size up to the maximum value set by the decoder.

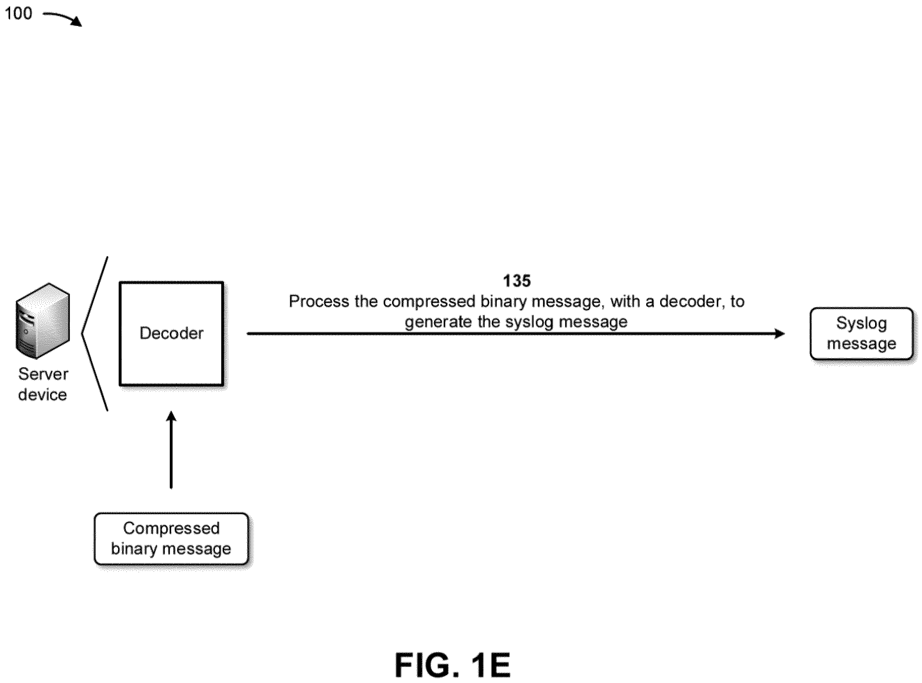

As further shown in Fig. 1A, and by reference number 125, the network device may provide the compressed binary message to a server device. For example, the server device may be a syslog server that receives syslog messages, monitors syslog messages, and/or stores syslog messages received from the network devices. In some implementations, the network device may provide the compressed binary message (e.g., which is based on the syslog message) to the server device and the server device may receive the compressed binary message. In some implementations, the server device may process the compressed binary message, with a decoder, to generate the syslog message. The decoder may include a header compression for HTTP decoder, a header compression for syslog attribute pairs similar to HTTP/2 decoder, and/or the like. Further details of processing the compressed binary message with the decoder are provided below in connection with Figs. 1E-1H.

In some implementations, the server device may perform one or more actions based on the syslog message. For example, the server device may enable a network administrator to monitor and manage the syslog message and the network device from different parts of the network. In another example, the server device may utilize the syslog message to analyze traffic patterns and/or subscriber usage, for billing purposes, and/or the like.

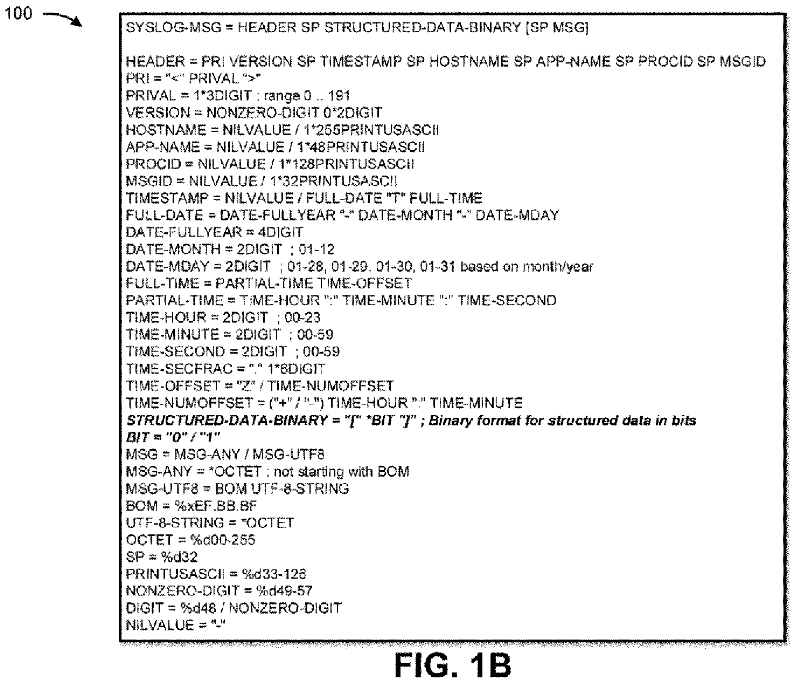

Fig. 1B provides an example of a syslog message that may be generated by the network device. As shown, the syslog message may include a HEADER field, a PRI field, a VERSION field, a HOSTNAME field, an APP-NAME field, a PROCID field, a MSGID field, a TIMESTAMP field, a FULL-DATE field, a DATE-FULLYEAR field, a DATE-MONTH field, a DATE-MDAY field, a FULL-TIME field, a PARTIAL-TIME field, a TIME-HOUR field, a TIME-MINUTE field, a TIME-SECOND field, a TIME-SECFRAC field, a TIME-OFFSET field, a TIME-NUMOFFSET field, a STRUCTURED-DATA-BINARY field, a BIT field, a MSG field, a MSG-ANY field, a MSG-UTF8 field, a BOM field, a UTF-8-STRING field, an OCTET field, an SP field, a PRINTUSASCII field, a NONZERO-DIGIT field, a DIGIT field, a NILVALUE field, and/or the like. The fields may include features of existing fields in syslog messages, unless otherwise described herein.

The VERSION field may denote a version of the syslog protocol specification. The version number may be incremented (e.g., to a value of two). With this version, the structured binary data may require interpretation as per the below-mentioned syslog frame format. In case there is a mismatch in what is received, the server device may drop the compressed binary message. The content of the STRUCTURED-DATA-BINARY field may include a syslog frame format as described below. A syslog message may include multiple syslog frames. All frames may begin with a fixed 4-octet attribute followed by a variable-length frame payload: *Syslog Frame {Length (24), Type (8), Frame Payload (..), }*. The length may refer to a length of the frame payload expressed as an unsigned 24-bit integer in units of octets. The type may refer to an 8-bit type of the frame. The frame type may determine the format and semantics of the frame. The structure and content of the frame payload are dependent entirely on the frame type. The size of a frame payload is limited by the maximum size that a sending device advertises in a SETTINGS_MAX_FRAME_SIZE setting.

The frame types may include a SETTINGS frame, a STRUCTURED-DATA-BINARY frame, and a CONTINUATION frame. The SETTINGS frame may be used for sending control information. The STRUCTURED-DATA-BINARY and CONTINUATION frames may follow either one of literal attribute field representations. The SETTINGS frame may convey configuration parameters that affect how the network device communicates to the server device, such as preferences and constraints. Individually, a configuration parameter from the SETTINGS frame may be referred to as a setting. Settings describe characteristics of the sending network device, which are used by the receiving server device. Different values for the same settings may be advertised by the network device. Each parameter in a SETTINGS frame may replace any existing value for that parameter. Settings may be processed in the order in which they appear, and a receiver of a SETTINGS frame does not need to maintain any state other than the current value of each setting. Therefore, the value of a settings parameter is the last value that is seen by a receiver.

The frame payload of a SETTINGS frame may include zero or more settings, each consisting of an unsigned 16-bit setting identifier and an unsigned 32-bit value. A SETTINGS frame may include the following format: *SETTINGS Frame {Length (24), Type (8) = 0x01, Settings (48) ...,},* where the Settings include the format *Settings {Identifier (16), Value (32),}.* The length and the type are described above, and the frame payload of a SETTINGS frame may include any number of Setting fields, each of which includes an identifier (e.g., a 16-bit setting identifier) and a value (e.g., a 32-bit value for the setting). One defined setting may include the SETTINGS_HEADER_TABLE_SIZE setting, which enables the network device to inform the receiving device of the maximum size of the compression table used to decode field blocks, in units of octets. The encoder can select any size equal to or less than this value by using signaling specific to the compression format inside a field block. Most values in SETTINGS benefit from or may require an understanding of when a peer device has received and applied the changed parameter values. In order to provide such synchronization timepoints, the recipient of a SETTINGS frame may apply the updated settings as soon as possible upon receipt.

The STRUCTURED-DATA frame may be used to carry a field block fragment and may include the following format: *STRUCTURED-DATA Frame {Length (24), Type (8) = 0x01, Unused Flags (6), PADDED Flag (1), END*_*STRUCTURED_DATA Flag (1), [Pad Length (8)], Field Block Fragment (.), Padding (..2040),}.* A field block fragment is described elsewhere herein. The padding may include padding octets that contain no application semantic value. The pad length may include an 8-bit field containing the length of the frame padding in units of octets. The STRUCTURED-DATA frame may define the following flags: a PADDED flag (e.g., when set, indicates that the Pad Length field and any padding that it describes are present), and an END_STRUCTURED_DATA flag (e.g., when set, indicates that this frame contains an entire field block and is not followed by any CONTINUATION frames). A STRUCTURED-DATA frame without the END_STRUCTURED_DATA flag set may be followed by a CONTINUATION frame. A field block that does not fit within a STRUCTURED-DATA frame is continued in a CONTINUATION frame.

The CONTINUATION frame may be used to continue a sequence of field block fragments. Any quantity of CONTINUATION frames can be sent, as long as the preceding frame is a STRUCTURED-DATA frame or a CONTINUATION frame without the END_STRUCTURED_*DATA* flag set. The CONTINUATION frame may include the following format: *CONTINUATION Frame {Length (24), Type (8) = 0x09, Unused Flags (7), END_STRUCTURED_DATA Flag (1), Field Block Fragment (..),}.* The length and type fields are described elsewhere herein. The CONTINUATION frame payload contains a field block fragment. The CONTINUATION frame may define the following flag: END_STRUCTURED_DATA flag (e.g., when set, indicates that this frame ends a field block). If the END_STRUCTURED_DATA flag is not set, this frame may be followed by another CONTINUATION frame. A receiver may treat the receipt of any other type of frame as a connection error. A CONTINUATION frame may be preceded by a STRUCTURED-DATA frame.

As shown in Fig. 1C, and by reference number 130, the network device may process the syslog message, with an encoder, to identify attribute fields and to generate an attribute list and a dynamic table. For example, the network device may be associated with an encoder that processes the syslog message and generates the binary message and the compressed binary message (e.g., the dynamic table) based on processing the syslog message. As further shown in Fig. 1C, an example syslog message may include the following syntax: *1 2020-11-26T11:33:03.494Z blades RT_FLOW - RT_FLOW_SESSION_CREATE_USF [service-set-name="sset1" source-address="50.50.50.2" source-port="51420" destination-address="60.60.60.2" destination-port="2000" session-id="21990232555528"].* In some implementations, the network device may process the syslog message, with the encoder, to identify the attribute fields, to generate the attribute list based on the attribute fields, and to generate the dynamic table based on the attribute list.

The encoder may treat a list of attribute fields as an ordered collection of name-value pairs that can include duplicate pairs. The encoder may consider names and values to be an opaque sequence of octets, and may preserve the order of attribute fields after being compressed and decompressed. The encoder may be informed by attribute field tables that map attribute fields to indexed values. These field tables can be incrementally updated as new attribute fields are encoded or decoded. In an encoded form, an attribute field is represented either literally or as a reference to an attribute field table. Therefore, a list of attribute fields can be encoded using a mixture of references and literal values. Literal values are either encoded directly or use a static Huffman code. The encoder may determine which attribute fields to insert as new entries in the attribute field tables. The decoder (e.g., in the server device) may execute modifications to the attribute field tables prescribed by the encoder, reconstructing the list of attribute fields in the process. This may enable the decoder to remain simple and interoperate with a wide variety of encoders.

An attribute field is a name-value pair where both the name and the value are treated as opaque sequences of octets. A dynamic table is a table that associates stored attribute fields with index values. This table is dynamic and specific to an encoding or decoding context. A static table is a table that statically associates attribute fields that occur frequently with index values. This table is ordered, read-only, always accessible, and it may be shared among all encoding or decoding contexts. The static table may be a radius vendor specific attributes (VSA) table with a maximum size (e.g., two-hundred and fifty-six entries). Each vendor may define specific attributes and for syslog messages the static table may utilize common attributes. Since syslog messages are specific to each vendor, a radius VSA table may be redefined as the static table. An attribute list is an ordered collection of attribute fields that are encoded jointly and can contain duplicate attribute fields. A complete list of attribute fields contained in a syslog attribute block is an attribute list. An attribute field representation is a representation of an attribute field in encoded form either as a literal or as an index. An attribute block is an ordered list of attribute field representations which, when decoded, yields a complete attribute list.

The encoder may preserve the ordering of attribute fields inside the attribute list. The encoder may order attribute field representations in the attribute block according to their ordering in the original attribute list. The decoder may order attribute fields in the decoded attribute list according to their ordering the attribute block.

The network device and/or the server device may utilize two tables for associating attribute fields to indexes. The static table is predefined and contains common attribute fields. The dynamic table is dynamic and can be used by the encoder to index attribute fields repeated in the encoded attribute lists. These two tables may be combined into a single address space for defining index values. The static table may include a predefined static list of attribute fields. The dynamic table may include a list of attribute fields maintained in a first-in, first-out order. The first and newest entry in a dynamic table is at the lowest index, and the oldest entry of a dynamic table is at the highest index. The dynamic table may be initially empty and entries may be added as each attribute block is decompressed. The dynamic table can contain duplicate entries (i.e., entries with the same name and same value). The encoder may determine how to update the dynamic table and as a result can control how much memory is used by the dynamic table. To limit the memory requirements of the decoder, the dynamic table size may be strictly bounded. The decoder may update the dynamic table during the processing of a list of attribute field representations.

The static table and the dynamic table may be combined into a single index address space. Indices between one and the length of the static table may refer to elements in the static table. Indices greater than the length of the static table may refer to elements in the dynamic table. The length of the static table may be subtracted to find the index into the dynamic table.

An encoded attribute field can be represented either as an index or as a literal presentation. An indexed representation may define an attribute field as a reference to an entry in either the static table or the dynamic table. A literal presentation may define an attribute field by specifying its name and value. The attribute field name can be represented literally or as a reference to an entry in either the static table or the dynamic table. The attribute field value may be represented literally. A literal representation may add the attribute field as a new entry at the beginning of the dynamic table. Alternatively, a literal representation may not add the attribute field to the dynamic table. Alternatively, a literal representation may not add the attribute field to the dynamic table, with the additional stipulation that this attribute field always use a literal representation, in particular when re-encoded by an intermediary. This representation is intended for protecting attribute field values that are not to be put at risk by compressing them. The selection of one of these literal presentations may be guided by security considerations in order to protect sensitive attribute field values. The literal presentation of an attribute field name or of an attribute field value can encode the sequence of octets either directly or using a static Huffman code.

Fig. 1D depicts how the encoder of the network device may process the syslog message, such as the example syslog message shown in Fig. 1C. For example, the encoder may process the example syslog message to identify the following attribute fields: *service-set-name="sset1"*; *source-address="50.50.50.2"*; *...; session-id="21990232555528".* The encoder may generate the attribute list based on the attribute fields. The attributes list may include the following: *service-set-name="sset1" source-address="50.50.50.2" source-port="51420" destination-address="60.60.60.2" destination-port="2000" session-id="21990232555528".* Finally, the encoder may generate the dynamic table based on the attribute list. The dynamic table may include the following information:

| | | | |
|---|---|---|---|
| *4010 7365 7276 6963 652D 7365 742D 6E61 6D65* | | | *service-set-name* |
| | *0573 7365 7431* | | *set1* |
| *400E 736F 7572 6365 2D61 6464 7265 7373* | | *source-address* | |
| | *0A35 302E 3530 2E35 302E 32* | | *50.50.50.2* |
| *400B 736F 7572 6365 2D70 6F72 74* | | *source-port* | |
| | *0535 3134 3230* | | *51420* |
| *4013 6465 7374 696E 6174 696F 6E2D 6164 6472 6573 73* | | *destination-address* | |
| | *0A36 302E 3630 2E36 302E 32* | | *60.60.60.2* |
| *4010 6465 7374 696E 6174 696F 6E2D 706F 7274* | | | *destination-port* |
| | *0432 3030 30* | | *2000* |
| *400A 7365 7373 696F 6E2D 6964* | | | *session-id* |
| | *0E32 3139 3930 3233 3235 3535 3532 38* | *21990232555528* | |

As shown in Fig. 1E, and by reference number 135, the server device may process the compressed binary message, with a decoder, to generate the syslog message. For example, the server device may be associated with a decoder that processes compressed binary message and generates the syslog message based on the processing the compressed binary message. In some implementations, the decoder may process an attribute block sequentially to reconstruct the original attribute list. An attribute block is the concatenation of attribute field representations. The different possible attribute field representations are described elsewhere herein. Once an attribute field is decoded and added to the reconstructed attribute list, the attribute field cannot be removed. An attribute field added to the attribute list can be safely passed to an application. By passing the resulting attribute fields to the application, a decoder can be implemented with minimal transitory memory commitment in addition to the memory required for the dynamic table. In some implementations, the decoder may decompress the binary message to generate a system message, and may provide the system message to a syslog application for interpretation.

The decoder may process an attribute block to obtain an attribute list. To ensure that the decoding will successfully produce an attribute list, a decoder may obey the following rules. The decoder may process all the attribute field representations contained in an attribute block in the order in which they appear. For an indexed representation, the attribute field in either the static table or the dynamic table may be appended to the decoded attribute list. For a literal representation that is not added to the dynamic table, the attribute field may be appended to the decoded attribute list. For a literal representation that is added to the dynamic table, the attribute field may be appended to the decoded attribute list and the attribute field may be inserted at the beginning of the dynamic table. A size of the dynamic table may be a sum of the size of its entries. The size of an entry may be a sum of its name's length in octets, its value's length in octets, and an overhead number. The size of an entry may be calculated using the length of its name and value without any Huffman encoding applied.

The decoder may evict an entry from the dynamic table when the size of the dynamic table changes. For example, whenever the maximum size for the dynamic table is reduced, entries may be evicted from the end of the dynamic table until the size of the dynamic table is less than or equal to the maximum size. The decoder may evict an entry from the dynamic table when new entries are to be added to the dynamic table. For example, before a new entry is added to the dynamic table, entries may be evicted from the end of the dynamic table until the size of the dynamic table is less than or equal to the maximum size less the new entry size or until the dynamic table is empty.

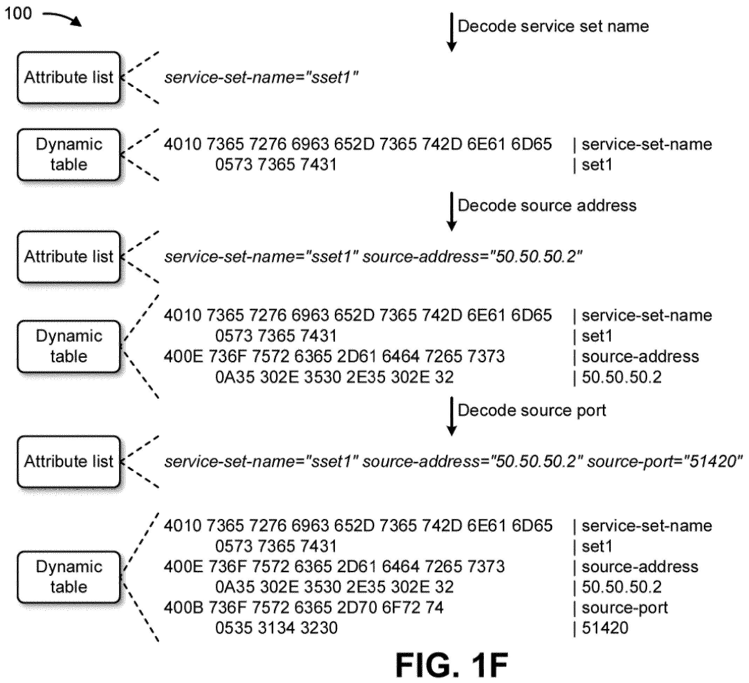

Figs. 1F-1H depict how the decoder of the server device may process the compressed binary message to generate the syslog message. As shown in Fig. 1F, the decoder may decode the service set name of the compressed binary message and may add the service set name to the attribute list and the dynamic table. The service set name added to the attribute list may be *service-set-name="sset1"* and the dynamic table entry may be *4010 7365 7276 6963 652D 7365 742D 6E61 6D65* | *service-set-name* and *0573 7365 7431* | *set1.* As further shown in Fig. 1F, the decoder may decode the source address of the compressed binary message and may add the source address to the attribute list and the dynamic table. The source address added to the attribute list may be *source-address="50.50.50.2"* and the dynamic table entry may be *400E 736F 7572 6365 2D61 6464 7265 7373* | *source-address* and *0A35 302E 3530 2E35 302E 32* | *50.50.50.2.* As further shown in Fig. 1F, the decoder may decode the source port of the compressed binary message and may add the source port to the attribute list and the dynamic table. The source port added to the attribute list may be *source-port="51420"* and the dynamic table entry may be *400B 736F 7572 6365 2D70 6F72 74* | *source-port* and *0535 3134 3230* | *51420.*

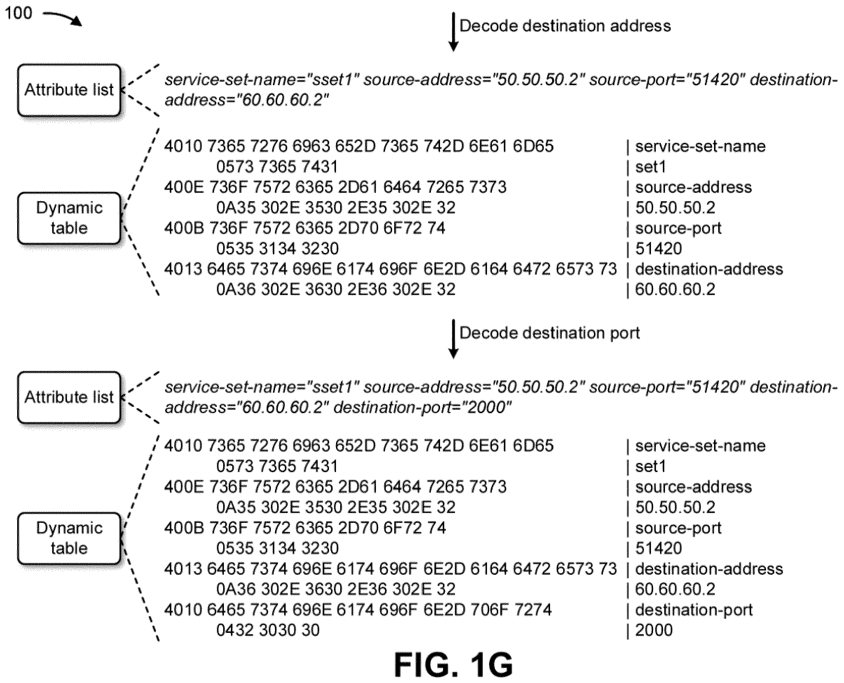

As shown in Fig. 1G, the decoder may decode the destination address of the compressed binary message and may add the destination address to the attribute list and the dynamic table. The destination address added to the attribute list may be *destination-address="60.60.60.2"* and the dynamic table entry may be *4013 6465 7374 696E 6174 696F 6E2D 6164 6472 6573 73* | *destination-address* and *0A36 302E 3630 2E36 302E 32* | *60.60.60.2.* As further shown in Fig. 1G, the decoder may decode the destination port of the compressed binary message and may add the destination port to the attribute list and the dynamic table. The destination port added to the attribute list may be *destination-port="2000"* and the dynamic table entry may be *4010 6465 7374 696E 6174 696F 6E2D 706F 7274* | *destination-port* and *0432 3030 30* | *2000.*

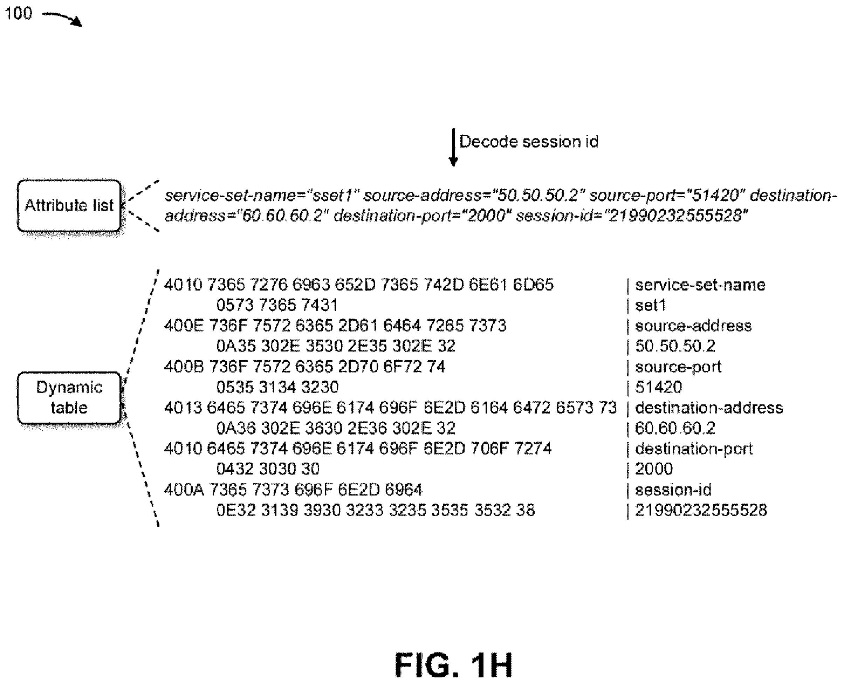

As shown in Fig. 1H, the decoder may decode the session id (ID) of the compressed binary message and may add the session id to the attribute list and the dynamic table. The session id added to the attribute list may be *session-id="21990232555528"* and the dynamic table entry may be *400A 7365 7373 696F 6E2D 6964* | *session-id* and *0E32 3139 3930 3233 3235 3535 3532 38* | *21990232555528.*

In this way, the network device reduces a memory size of a system generated message prior to transmission. For example, the network device may provide a new framer layer to a syslog message. The new framer layer may enable the network device to convert a syslog message from textual format to a binary format, and compress the binary formatted syslog message to generate a compressed binary syslog message. The network device may forward the compressed binary syslog message to a server device for further processing. Thus, the network device conserves computing resources, networking resources, and/or the like that would otherwise have been consumed by failing to reduce memory sizes of large quantities of syslog messages, restricting bandwidth of a network device and/or a network based on failing to reduce the memory sizes of the large quantities of syslog messages, causing lost traffic in a network based on failing to reduce the memory sizes of the large quantities of syslog messages, and/or the like.

As indicated above, Figs. 1A-1H are provided as an example. Other examples may differ from what is described with regard to Figs. 1A-1H. The number and arrangement of devices shown in Figs. 1A-1H are provided as an example. In practice, there may be additional devices, fewer devices, different devices, or differently arranged devices than those shown in Figs. 1A-1H. Furthermore, two or more devices shown in Figs. 1A-1H may be implemented within a single device, or a single device shown in Figs. 1A-1H may be implemented as multiple, distributed devices. Additionally, or alternatively, a set of devices (e.g., one or more devices) shown in Figs. 1A-1H may perform one or more functions described as being performed by another set of devices shown in Figs. 1A-1H.

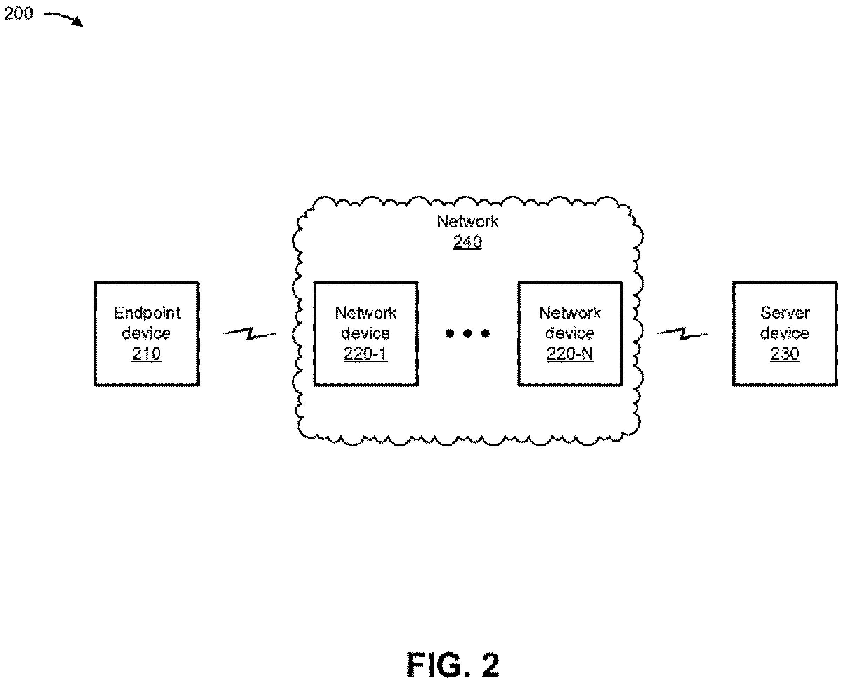

Fig. 2 is a diagram of an example environment 200 in which systems and/or methods described herein may be implemented. As shown in Fig. 2, the environment 200 may include an endpoint device 210, a group of network devices 220 (shown as network device 220-1 through network device 220-N), a server device 230, and a network 240. Devices of the environment 200 may interconnect via wired connections, wireless connections, or a combination of wired and wireless connections.

The endpoint device 210 includes one or more devices capable of receiving, generating, storing, processing, and/or providing information, such as information described herein. For example, the endpoint device 210 may include a mobile phone (e.g., a smart phone or a radiotelephone), a laptop computer, a tablet computer, a desktop computer, a handheld computer, a gaming device, a wearable communication device (e.g., a smart watch, a pair of smart glasses, a heart rate monitor, a fitness tracker, smart clothing, smart jewelry, or a head mounted display), a network device, or a similar type of device. In some implementations, the endpoint device 210 may receive network traffic from and/or may provide network traffic to other endpoint devices 210 and/or the server device 230, via the network 240 (e.g., by routing packets using the network devices 220 as intermediaries).

The network device 220 includes one or more devices capable of receiving, processing, storing, routing, and/or providing traffic (e.g., a packet or other information or metadata) in a manner described herein. For example, the network device 220 may include a router, such as a label switching router (LSR), a label edge router (LER), an ingress router, an egress router, a provider router (e.g., a provider edge router or a provider core router), a virtual router, or another type of router. Additionally, or alternatively, the network device 220 may include a gateway, a switch, a firewall, a hub, a bridge, a reverse proxy, a server (e.g., a proxy server, a cloud server, or a data center server), a load balancer, and/or a similar device. In some implementations, the network device 220 may be a physical device implemented within a housing, such as a chassis. In some implementations, the network device 220 may be a virtual device implemented by one or more computer devices of a cloud computing environment or a data center. In some implementations, a group of network devices 220 may be a group of data center nodes that are used to route traffic flow through the network 240.

The server device 230 may include one or more devices capable of receiving, generating, storing, processing, providing, and/or routing information, as described elsewhere herein. The server device 230 may include a communication device and/or a computing device. For example, the server device 230 may include a server, such as an application server, a client server, a web server, a database server, a host server, a proxy server, a virtual server (e.g., executing on computing hardware), or a server in a cloud computing system. In some implementations, the server device 230 may include computing hardware used in a cloud computing environment.

The network 240 includes one or more wired and/or wireless networks. For example, the network 240 may include a packet switched network, a cellular network (e.g., a fifth generation (5G) network, a fourth generation (4G) network, such as a long-term evolution (LTE) network, or a third generation (3G) network), a code division multiple access (CDMA) network, a public land mobile network (PLMN), a local area network (LAN), a wide area network (WAN), a metropolitan area network (MAN), a telephone network (e.g., the Public Switched Telephone Network (PSTN)), a private network, an ad hoc network, an intranet, the Internet, a fiber optic-based network, a cloud computing network, or the like, and/or a combination of these or other types of networks.

The number and arrangement of devices and networks shown in Fig. 2 are provided as an example. In practice, there may be additional devices and/or networks, fewer devices and/or networks, different devices and/or networks, or differently arranged devices and/or networks than those shown in Fig. 2. Furthermore, two or more devices shown in Fig. 2 may be implemented within a single device, or a single device shown in Fig. 2 may be implemented as multiple, distributed devices. Additionally, or alternatively, a set of devices (e.g., one or more devices) of environment 200 may perform one or more functions described as being performed by another set of devices of environment 200.

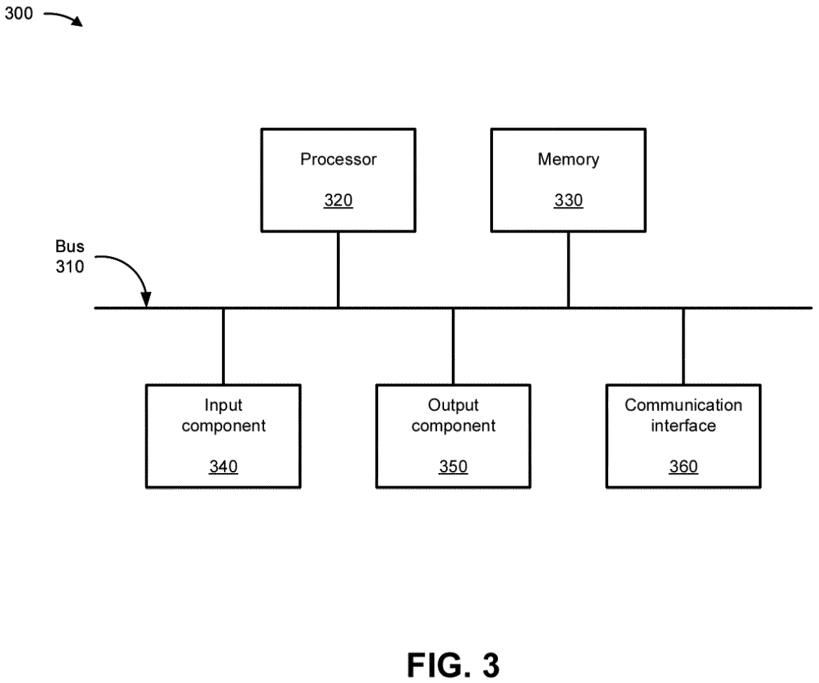

Fig. 3 is a diagram of example components of one or more devices of Fig. 2. The example components may be included in a device 300, which may correspond to the endpoint device 210, the network device 220, and/or the server device 230. In some implementations, the endpoint device 210, the network device 220, and/or the server device 230 may include one or more devices 300 and/or one or more components of the device 300. As shown in Fig. 3, the device 300 may include a bus 310, a processor 320, a memory 330, an input component 340, an output component 350, and a communication interface 360.

The bus 310 includes one or more components that enable wired and/or wireless communication among the components of the device 300. The bus 310 may couple together two or more components of Fig. 3, such as via operative coupling, communicative coupling, electronic coupling, and/or electric coupling. The processor 320 includes a central processing unit (CPU), a graphics processing unit (GPU), a microprocessor, a controller, a microcontroller, a digital signal processor (DSP), a field-programmable gate array (FPGA), an application-specific integrated circuit (ASIC), and/or another type of processing component. The processor 320 is implemented in hardware, firmware, or a combination of hardware and software. In some implementations, the processor 320 includes one or more processors capable of being programmed to perform one or more operations or processes described elsewhere herein.

The memory 330 includes volatile and/or nonvolatile memory. For example, the memory 330 may include random access memory (RAM), read only memory (ROM), a hard disk drive, and/or another type of memory (e.g., a flash memory, a magnetic memory, and/or an optical memory). The memory 330 may include internal memory (e.g., RAM, ROM, or a hard disk drive) and/or removable memory (e.g., removable via a universal serial bus connection). The memory 330 may be a non-transitory computer-readable medium. The memory 330 stores information, instructions, and/or software (e.g., one or more software applications) related to the operation of the device 300. In some implementations, the memory 330 includes one or more memories that are coupled to one or more processors (e.g., the processor 320), such as via the bus 310.

The input component 340 enables the device 300 to receive input, such as user input and/or sensed input. For example, the input component 340 may include a touch screen, a keyboard, a keypad, a mouse, a button, a microphone, a switch, a sensor, a global positioning system sensor, an accelerometer, a gyroscope, and/or an actuator. The output component 350 enables the device 300 to provide output, such as via a display, a speaker, and/or a light-emitting diode. The communication interface 360 enables the device 300 to communicate with other devices via a wired connection and/or a wireless connection. For example, the communication interface 360 may include a receiver, a transmitter, a transceiver, a modem, a network interface card, and/or an antenna.

The device 300 may perform one or more operations or processes described herein. For example, a computer-readable medium (e.g., the memory 330) may store a set of instructions (e.g., one or more instructions or code) for execution by the processor 320. Such a computer-readable storage medium may be referred to as a non-transitory computer-readable medium. Examples of a computer-readable storage medium may include a CD, a DVD, a storage device, a diskette, a tape, flash memory, physical memory, or any other computer-readable storage medium. A computer-readable medium may also or alternatively be a transmission medium by which instructions may be conveyed. A computer-readable transmission medium may include carrier waves, transmission signals or the like. A computer-readable transmission medium may convey instructions between components of a single computer system and/or between plural separate computer systems. The processor 320 may execute the set of instructions to perform one or more operations or processes described herein. In some implementations, execution of the set of instructions, by one or more processors 320, causes the one or more processors 320 and/or the device 300 to perform one or more operations or processes described herein. In some implementations, hardwired circuitry may be used instead of or in combination with the instructions to perform one or more operations or processes described herein. Additionally, or alternatively, the processor 320 may be configured to perform one or more operations or processes described herein. Thus, implementations described herein are not limited to any specific combination of hardware circuitry and software.

The number and arrangement of components shown in Fig. 3 are provided as an example. The device 300 may include additional components, fewer components, different components, or differently arranged components than those shown in Fig. 3. Additionally, or alternatively, a set of components (e.g., one or more components) of the device 300 may perform one or more functions described as being performed by another set of components of the device 300.

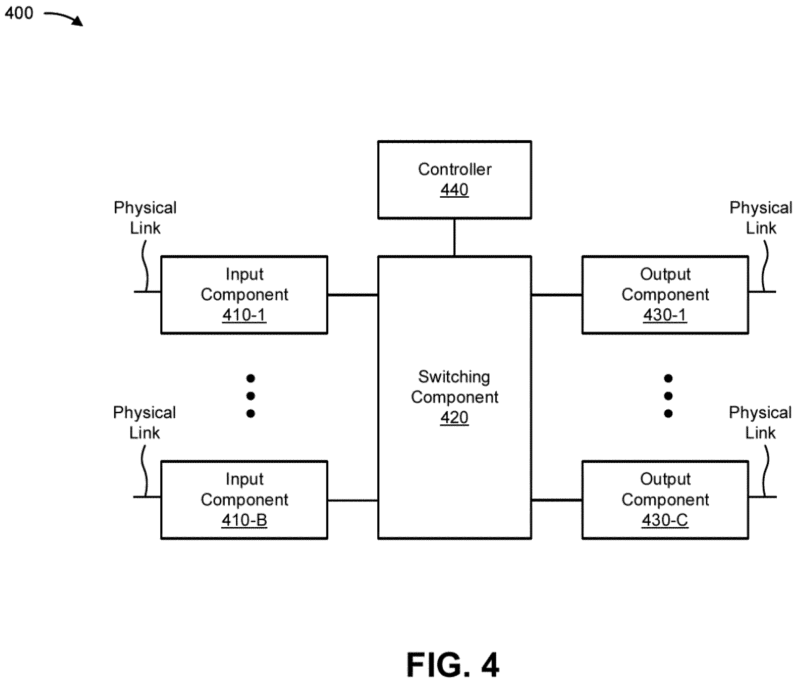

Fig. 4 is a diagram of example components of one or more devices of Fig. 2. The example components may be included in a device 400. The device 400 may correspond to the network device 220. In some implementations, the network device 220 may include one or more devices 400 and/or one or more components of the device 400. As shown in Fig. 4, the device 400 may include one or more input components 410-1 through 410-B (B ≥ 1) (hereinafter referred to collectively as input components 410, and individually as input component 410), a switching component 420, one or more output components 430-1 through 430-C (C ≥ 1) (hereinafter referred to collectively as output components 430, and individually as output component 430), and a controller 440.

The input component 410 may be one or more points of attachment for physical links and may be one or more points of entry for incoming traffic, such as packets. The input component 410 may process incoming traffic, such as by performing data link layer encapsulation or decapsulation. In some implementations, the input component 410 may transmit and/or receive packets. In some implementations, the input component 410 may include an input line card that includes one or more packet processing components (e.g., in the form of integrated circuits), such as one or more interface cards (IFCs), packet forwarding components, line card controller components, input ports, processors, memories, and/or input queues. In some implementations, the device 400 may include one or more input components 410.

The switching component 420 may interconnect the input components 410 with the output components 430. In some implementations, the switching component 420 may be implemented via one or more crossbars, via busses, and/or with shared memories. The shared memories may act as temporary buffers to store packets from the input components 410 before the packets are eventually scheduled for delivery to the output components 430. In some implementations, the switching component 420 may enable the input components 410, the output components 430, and/or the controller 440 to communicate with one another.

The output component 430 may store packets and may schedule packets for transmission on output physical links. The output component 430 may support data link layer encapsulation or decapsulation, and/or a variety of higher-level protocols. In some implementations, the output component 430 may transmit packets and/or receive packets. In some implementations, the output component 430 may include an output line card that includes one or more packet processing components (e.g., in the form of integrated circuits), such as one or more IFCs, packet forwarding components, line card controller components, output ports, processors, memories, and/or output queues. In some implementations, the device 400 may include one or more output components 430. In some implementations, the input component 410 and the output component 430 may be implemented by the same set of components (e.g., and input/output component may be a combination of the input component 410 and the output component 430).

The controller 440 includes a processor in the form of, for example, a CPU, a GPU, an accelerated processing unit (APU), a microprocessor, a microcontroller, a DSP, an FPGA, an ASIC, and/or another type of processor. The processor is implemented in hardware, firmware, or a combination of hardware and software. In some implementations, the controller 440 may include one or more processors that can be programmed to perform a function.

In some implementations, the controller 440 may include a RAM, a ROM, and/or another type of dynamic or static storage device (e.g., a flash memory, a magnetic memory, an optical memory, etc.) that stores information and/or instructions for use by the controller 440.

In some implementations, the controller 440 may communicate with other devices, networks, and/or systems connected to the device 400 to exchange information regarding network topology. The controller 440 may create routing tables based on the network topology information, may create forwarding tables based on the routing tables, and may forward the forwarding tables to the input components 410 and/or output components 430. The input components 410 and/or the output components 430 may use the forwarding tables to perform route lookups for incoming and/or outgoing packets.

The controller 440 may perform one or more processes described herein. The controller 440 may perform these processes in response to executing software instructions stored by a computer-readable storage medium. A computer-readable medium may be a non-transitory memory device. A memory device includes memory space within a single physical storage device or memory space spread across multiple physical storage devices. Such a computer-readable storage medium may also be referred to as a non-transitory computer-readable medium. Examples of a computer-readable storage medium may include a CD, a DVD, a storage device, a diskette, a tape, flash memory, physical memory, or any other computer-readable storage medium. A computer-readable medium may also or alternatively be a transmission medium by which instructions may be conveyed. A computer-readable transmission medium may include carrier waves, transmission signals or the like. A computer-readable transmission medium may convey instructions between components of a single computer system and/or between plural separate computer systems.

Software instructions may be read into a memory and/or storage component associated with the controller 440 from another computer-readable medium or from another device via a communication interface. When executed, software instructions stored in a memory and/or storage component associated with the controller 440 may cause the controller 440 to perform one or more processes described herein. Additionally, or alternatively, hardwired circuitry may be used in place of or in combination with software instructions to perform one or more processes described herein. Thus, implementations described herein are not limited to any specific combination of hardware circuitry and software.

The number and arrangement of components shown in Fig. 4 are provided as an example. In practice, the device 400 may include additional components, fewer components, different components, or differently arranged components than those shown in Fig. 4. Additionally, or alternatively, a set of components (e.g., one or more components) of the device 400 may perform one or more functions described as being performed by another set of components of the device 400.

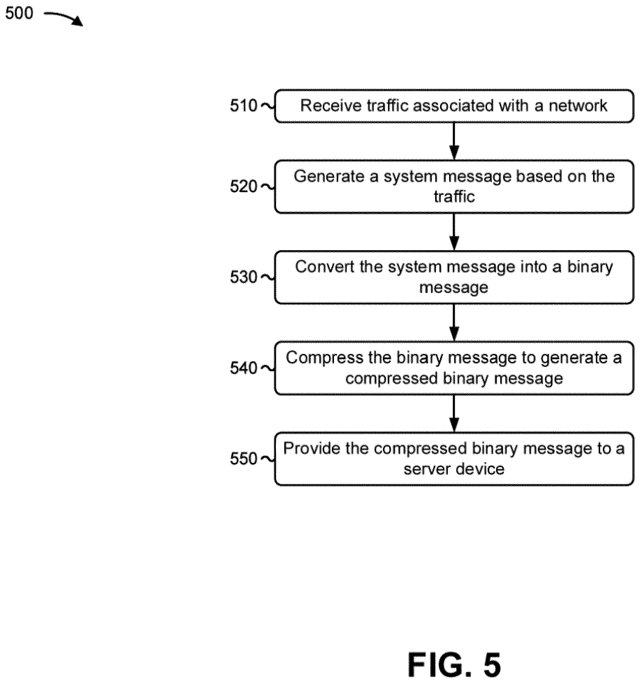

Fig. 5 is a flowchart of an example process 500 for reducing a memory size of a system generated message prior to transmission. In some implementations, one or more process blocks of Fig. 5 may be performed by a network device (e.g., the network device 220). In some implementations, one or more process blocks of Fig. 5 may be performed by another device or a group of devices separate from or including the network device, such as a server device (e.g., the server device 230). Additionally, or alternatively, one or more process blocks of Fig. 5 may be performed by one or more components of the device 300, such as the processor 320, the memory 330, the input component 340, the output component 350, and/or the communication interface 360. Additionally, or alternatively, one or more process blocks of Fig. 5 may be performed by one or more components of the device 400, such as the input component 410, the switching component 420, the output component 430, and/or the controller 440.

As shown in Fig. 5, process 500 may include receiving traffic associated with a network (block 510). For example, the network device may receive traffic associated with a network, as described above.

As further shown in Fig. 5, process 500 may include generating a system message based on the traffic (block 520). For example, the network device may generate a system message based on the traffic, as described above.

As further shown in Fig. 5, process 500 may include converting the system message into a binary message (block 530). For example, the network device may convert the system message into a binary message, as described above. In some implementations, converting the system message into the binary message includes processing the system message, with an encoder, to identify attribute fields, to generate an attribute list based on the attribute fields, and to generate a table based on the attribute list, wherein the binary message corresponds to the table. In some implementations, the encoder is a header compression for HTTP encoder, a header compression for syslog attribute pairs similar to HTTP/2 encoder, and/or the like. In some implementations, the table is maintained in a first-in, first-out order. In some implementations, the table is bounded by a memory threshold.

In some implementations, the binary message includes a frame handler layer provided above a transport layer of the system message. In some implementations, the binary message includes a version field indicating that the binary message includes structured binary data. In some implementations, the binary message includes a structured data frame configured to include a field block fragment. In some implementations, the binary message includes encoded binary data.

As further shown in Fig. 5, process 500 may include compressing the binary message to generate a compressed binary message (block 540). For example, the network device may compress the binary message to generate a compressed binary message, as described above. In some implementations, compressing the binary message to generate the compressed binary message includes compressing a set of field lines of the binary message to generate a field block that corresponds to the compressed binary message.

As further shown in Fig. 5, process 500 may include providing the compressed binary message to a server device (block 550). For example, the network device may provide the compressed binary message to a server device, as described above. In some implementations, providing the compressed binary message to the server device includes providing the compressed binary message to cause the server device to process the compressed binary message, with a decoder, to generate the system message. In some implementations, the decoder is a header compression for HTTP decoder, a header compression for syslog attribute pairs similar to HTTP/2 decoder, and/or the like.

In some implementations, process 500 includes performing Huffman encoding of the system message prior to converting the system message into the binary message.

Although Fig. 5 shows example blocks of process 500, in some implementations, process 500 may include additional blocks, fewer blocks, different blocks, or differently arranged blocks than those depicted in Fig. 5. Additionally, or alternatively, two or more of the blocks of process 500 may be performed in parallel.

Thus, from one perspective, there has/have now been described reducing a memory size of a system generated message prior to transmission. A network device may receive traffic associated with a network, and may generate a system message based on the traffic. The network device may convert the system message into a binary message, and may compress the binary message to generate a compressed binary message. The network device may provide the compressed binary message to a server device, and the server device may process the compressed binary message, with a decoder, to generate the system message.

The foregoing disclosure provides illustration and description but is not intended to be exhaustive or to limit the implementations to the precise form disclosed. Modifications may be made in light of the above disclosure or may be acquired from practice of the implementations.

As used herein, the term "component" is intended to be broadly construed as hardware, firmware, or a combination of hardware and software. It will be apparent that systems and/or methods described herein may be implemented in different forms of hardware, firmware, and/or a combination of hardware and software. The actual specialized control hardware or software code used to implement these systems and/or methods is not limiting of the implementations. Thus, the operation and behavior of the systems and/or methods are described herein without reference to specific software code - it being understood that software and hardware can be used to implement the systems and/or methods based on the description herein.

Although particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set.

No element, act, or instruction used herein should be construed as critical or essential unless explicitly described as such. Also, as used herein, the articles "a" and "an" are intended to include one or more items and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of").

In the preceding specification, various example embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded in an illustrative rather than restrictive sense.

## Claims

1. A method (500), comprising:
receiving (510), by a network device, traffic associated with a network;
generating (520), by the network device, a system message based on the traffic;
converting (530), by the network device, the system message into a binary message, wherein the binary message includes a structured data frame configured to include a field block fragment;
compressing (540), by the network device, the binary message to generate a compressed binary message; and
providing (550), by the network device, the compressed binary message to a server device.

2. The method of claim 1, wherein converting the system message into the binary message comprises:
processing the system message, with an encoder, to identify attribute fields, to generate an attribute list based on the attribute fields, and to generate a table based on the attribute list,
wherein the binary message corresponds to the table.

3. The method of claim 2, wherein the encoder is a header compression for hypertext transfer protocol, HTTP, encoder or a header compression for system log attribute pairs encoder.

4. The method of claim 2 or 3, wherein the table is maintained in a first-in, first-out order.

5. The method of any of claims 2-4, wherein the table is bounded by a memory threshold.

6. The method of any preceding claim, wherein providing the compressed binary message to the server device comprises:
providing the compressed binary message to cause the server device to process the compressed binary message, with a decoder, to generate the system message.

7. The method of claim 6, wherein the decoder is a header compression for hypertext transfer protocol, HTTP, decoder or a header compression for system log attribute pairs decoder.

8. A network device (200, 300, 400), comprising:
one or more memories (330); and
one or more processors (320) to:
receive traffic associated with a network (240);
generate a system message based on the traffic;
convert the system message into a binary message, wherein the binary message includes a structured data frame configured to include a field block fragment;
compress the binary message to generate a compressed binary message; and
provide the compressed binary message to a server device (230) to cause the server device to process the compressed binary message, with a decoder, to generate the system message.

9. The network device of claim 8, wherein the binary message includes a frame handler layer provided above a transport layer of the system message.

10. The network device of claim 8 or 9, wherein the binary message includes a version field indicating that the binary message includes structured binary data.

11. The network device of any of claims 8-10, wherein the one or more processors are further to:
perform Huffman encoding of the system message prior to converting the system message into the binary message.

12. The network device of any of claims 8-11, wherein the one or more processors, to compress the binary message to generate the compressed binary message, are to:
compress a set of field lines of the binary message to generate a field block that corresponds to the compressed binary message.

13. The network device of any of claims 8-12, wherein the binary message includes encoded binary data.

14. A computer-readable medium storing a set of instructions, the set of instructions comprising:
one or more instructions that, when executed by one or more processors of a network device (220), cause the network device to:
receive traffic associated with a network (240);
generate a system message based on the traffic;
process the system message, with an encoder, to identify attribute fields, to generate an attribute list based on the attribute fields, and to generate a table based on the attribute list,
wherein the table corresponds to a binary message, wherein the binary message includes a structured data frame configured to include a field block fragment;
compress the binary message to generate a compressed binary message; and
provide the compressed binary message to a server device (230).

## Patentansprüche

1. Verfahren (500), umfassend:
Empfangen (510) von Verkehr in Zusammenhang mit einem Netzwerk durch eine Netzwerkvorrichtung;
Erzeugen (520) einer Systemnachricht auf Basis des Verkehrs durch die Netzwerkvorrichtung;
Umwandeln (530) der Systemnachricht durch die Netzwerkvorrichtung in eine binäre Nachricht, wobei die binäre Nachricht einen strukturierten Datenrahmen beinhaltet, der so konfiguriert ist, dass er ein Feldblockfragment beinhaltet;
Komprimieren (540) der binären Nachricht durch die Netzwerkvorrichtung, um eine komprimierte binäre Nachricht zu erzeugen; und
Bereitstellen (550) der komprimierten binären Nachricht durch die Netzwerkvorrichtung für eine Servervorrichtung.

2. Verfahren nach Anspruch 1, wobei das Umwandeln der Systemnachricht in die binäre Nachricht umfasst:
Verarbeiten der Systemnachricht mit einem Encoder, um Attributfelder zu identifizieren, um auf Basis der Attributfelder eine Attributliste zu erzeugen und um auf Basis der Attributliste eine Tabelle zu erzeugen,
wobei die binäre Nachricht der Tabelle entspricht.

3. Verfahren nach Anspruch 2, wobei der Encoder ein Header-Compression-Encoder für Hypertext Transfer Protocol, HTTP, oder ein Header-Compression-Encoder für Systemprotokoll-Attributpaare ist.

4. Verfahren nach Anspruch 2 oder 3, wobei die Tabelle in einer First-In-First-Out-Reihenfolge geführt wird.

5. Verfahren nach einem der Ansprüche 2-4, wobei die Tabelle durch eine Speicherschwelle begrenzt ist.

6. Verfahren nach einem vorstehenden Anspruch, wobei das Bereitstellen der komprimierten binären Nachricht für die Servervorrichtung umfasst:
Bereitstellen der komprimierten binären Nachricht, um die Servervorrichtung dazu zu bringen, die komprimierte binäre Nachricht mit einem Decoder zu verarbeiten, um die Systemnachricht zu erzeugen.

7. Verfahren nach Anspruch 6, wobei der Decoder ein Header-Compression-Decoder für Hypertext Transfer Protocol, HTTP, oder ein Header-Compression-Decoder für Systemprotokoll-Attributpaare ist.

8. Netzwerkvorrichtung (200, 300, 400), umfassend:
einen oder mehrere Speicher (330); und
einen oder mehrere Prozessoren (320), um:
Verkehr in Zusammenhang mit einem Netzwerk (240) zu empfangen;
auf Basis des Verkehrs eine Systemnachricht zu erzeugen;
die Systemnachricht in eine binäre Nachricht umzuwandeln, wobei die binäre Nachricht einen strukturierten Datenrahmen beinhaltet, der so konfiguriert ist, dass er ein Feldblockfragment beinhaltet;
die binäre Nachricht zu komprimieren, um eine komprimierte binäre Nachricht zu erzeugen; und
die komprimierte binäre Nachricht einer Servervorrichtung (230) bereitzustellen, um die Servervorrichtung dazu zu bringen, die komprimierte binäre Nachricht mit einem Decoder zu verarbeiten, um die Systemnachricht zu erzeugen.

9. Netzwerkvorrichtung nach Anspruch 8, wobei die binäre Nachricht eine Frame-Handler-Schicht beinhaltet, die über einer Transportschicht der Systemnachricht bereitgestellt ist.

10. Netzwerkvorrichtung nach Anspruch 8 oder 9, wobei die binäre Nachricht ein Versionsfeld beinhaltet, das angibt, dass die binäre Nachricht strukturierte Binärdaten beinhaltet.

11. Netzwerkvorrichtung nach einem der Ansprüche 8-10, wobei der eine oder die mehreren Prozessoren weiter:
vor dem Umwandeln der Systemnachricht in die binäre Nachricht Huffman-Codierung der Systemnachricht durchführen.

12. Netzwerkvorrichtung nach einem der Ansprüche 8-11, wobei der eine oder die mehreren Prozessoren, um die binäre Nachricht zu komprimieren, um die komprimierte binäre Nachricht zu erzeugen:
einen Satz Feldzeilen der binären Nachricht komprimieren, um einen Feldblock zu erzeugen, der der komprimierten binären Nachricht entspricht.

13. Netzwerkvorrichtung nach einem der Ansprüche 8-12, wobei die binäre Nachricht codierte Binärdaten beinhaltet.

14. Computerlesbares Medium, das einen Satz von Anweisungen speichert, wobei der Satz von Anweisungen
umfasst:
eine oder mehrere Anweisungen, die, wenn sie von einem oder mehreren Prozessoren einer Netzwerkvorrichtung (220) ausgeführt werden, die Netzwerkvorrichtung dazu bringen:
Verkehr in Zusammenhang mit einem Netzwerk (240) zu empfangen;
auf Basis des Verkehrs eine Systemnachricht zu erzeugen;
die Systemnachricht mit einem Encoder zu verarbeiten, um Attributfelder zu identifizieren, um auf Basis der Attributfelder eine Attributliste zu erzeugen und um auf Basis der Attributliste eine Tabelle zu erzeugen,
wobei die Tabelle einer binären Nachricht entspricht, wobei die binäre Nachricht einen strukturierten Datenrahmen beinhaltet, der so konfiguriert ist, dass er ein Feldblockfragment beinhaltet;
die binäre Nachricht zu komprimieren, um eine komprimierte binäre Nachricht zu erzeugen; und
die komprimierte binäre Nachricht einer Servervorrichtung (230) bereitzustellen.

## Revendications

1. Procédé (500), comprenant :
une réception (510), par un dispositif réseau, d'un trafic associé à un réseau ;
une génération (520), par le dispositif réseau, d'un message système basé sur le trafic ;
une conversion (530), par le dispositif réseau, du message système en un message binaire, dans lequel le message binaire inclut une trame de données structurées configurée pour inclure un fragment de bloc de champ ;
une compression (540), par le dispositif réseau, du message binaire pour générer un message binaire compressé ; et
une fourniture (550), par le dispositif réseau, du message binaire compressé à un dispositif serveur.

2. Procédé selon la revendication 1, dans lequel la conversion du message système en le message binaire comprend :
un traitement du message système, avec un encodeur, pour identifier des champs d'attributs, pour générer une liste d'attributs basée sur les champs d'attributs, et pour générer une table basée sur la liste d'attributs,
dans lequel le message binaire correspond à la table.

3. Procédé selon la revendication 2, dans lequel l'encodeur est un encodeur de compression d'en-tête pour un protocole de transfert hypertexte, HTTP, ou un collecteur de compression d'entête pour des paires d'attributs de journal système.

4. Procédé selon la revendication 2 ou la revendication 3, dans lequel la table est maintenue dans un ordre premier entré, premier sorti.

5. Procédé selon l'une quelconque des revendications 2 à 4, dans lequel la table est limitée par un seuil de mémoire.

6. Procédé selon l'une quelconque des revendications précédentes, dans lequel la fourniture du message binaire compressé au dispositif serveur comprend :
une fourniture du message binaire compressé pour amener le dispositif serveur à traiter le message binaire compressé, avec un décodeur, afin de générer le message système.

7. Procédé selon la revendication 6, dans lequel le décodeur est un décodeur de compression d'en-tête pour un protocole de transfert hypertexte, HTTP, ou un décodeur de compression du collecteur pour des paires d'attributs de journal système.

8. Dispositif réseau (200, 300, 400), comprenant :
une ou plusieurs mémoires (330) ; et
un ou plusieurs processeurs (320) pour :
recevoir un trafic associé à un réseau (240) ;
générer un message système basé sur le trafic ;
convertir le message système en un message binaire, dans lequel le message binaire inclut une trame de données structurées configurée pour inclure un fragment de bloc de champ ;
compresser le message binaire pour générer un message binaire compressé ; et
fournir le message binaire compressé à un dispositif serveur (230) pour amener le dispositif serveur à traiter le message binaire compressé, avec un décodeur, afin de générer le message système.

9. Dispositif réseau selon la revendication 8, dans lequel le message binaire inclut une couche de gestion de trames prévue au-dessus d'une couche de transport du message système.

10. Dispositif réseau selon la revendication 8 ou la revendication 9, dans lequel le message binaire inclut un champ de version indiquant que le message binaire inclut des données binaires structurées.

11. Dispositif réseau selon l'une quelconque des revendications 8 à 10, dans lequel les un ou plusieurs processeurs sont en outre aptes à :
effectuer un codage de Huffman du message système avant de convertir le message système en le message binaire.

12. Dispositif réseau selon l'une quelconque des revendications 8 à 11, dans lequel les un ou plusieurs processeurs, afin de compresser le message binaire pour générer le message binaire compressé, doivent :
compresser un ensemble de lignes de champ du message binaire pour générer un bloc de champ qui correspond au message binaire compressé.

13. Dispositif réseau selon l'une quelconque des revendications 8 à 12, dans lequel le message binaire inclut des données binaires codées.

14. Support lisible par ordinateur stockant un ensemble d'instructions, l'ensemble d'instructions comprenant :
une ou plusieurs instructions qui, lorsqu'elles sont exécutées par un ou plusieurs processeurs d'un dispositif réseau (220), amènent le dispositif réseau à :
recevoir un trafic associé à un réseau (240) ;
générer un message système basé sur le trafic ;
traiter le message système, avec un encodeur, pour identifier des champs d'attributs, pour générer une liste d'attributs basée sur les champs d'attributs, et pour générer une table basée sur la liste d'attributs,
dans lequel la table correspond à un message binaire, dans lequel le message binaire inclut une trame de données structurées configurée pour inclure un fragment de bloc de champ ;
compresser le message binaire pour générer un message binaire compressé ; et
fournir le message binaire compressé à un dispositif serveur (230).
